# FASCICULE DE BREVET EUROPEEN

(11) **EP 3 371 128 B1**
(45) Date de publication et mention de la délivrance du brevet: **23.10.2019**
(21) Numéro de dépôt: 16793810.9
(22) Date de dépôt: 03.11.2016
(51) Int. Cl.: C04B 35/01, C04B 35/111, C04B 35/46, C04B 35/468, C04B 35/645, B22F 3/105, B28B 3/02, C04B 41/45, C04B 41/50, C04B 41/52, C23C 16/32

(54) **MATRICE ET PISTON D'APPAREIL DE SPS, APPAREIL DE SPS LES COMPRENANT, ET PROCEDE DE FRITTAGE, DENSIFICATION OU ASSEMBLAGE SOUS UNE ATMOSPHERE OXYDANTE UTILISANT CET APPAREIL.**
MATRIZE UND KOLBEN EINER SPS-VORRICHTUNG, SPS-VORRICHTUNG DIE DIE MATRIZE UND KOLBEN ENTHÄLT UND VERFAHREN ZUR SINTERUNG, VERDICHTUNG ODER ANORDNUNG IN EINER OXIDIERENDEN UMGEBUNG MIT VERWENDUNG DER BESAGTEN VORRICHTUNG
DIE AND PISTON OF AN SPS APPARATUS, SPS APPARATUS COMPRISING THE SAME, AND METHOD OF SINTERING, DENSIFICATION OR ASSEMBLY IN AN OXIDISING ATMOSPHERE USING SAID APPARATUS

(30) Priorité: 04.11.2015 FR 1560561
(43) Date de publication de la demande: 12.09.2018
(73) Titulaire: Commissariat à l'Energie Atomique et aux Energies Alternatives, 75015 Paris (FR); Centre National de la Recherche Scientifique, 75016 Paris (FR)
(72) Inventeur: ALLEMAND, Alexandre, 33000 Bordeaux (FR); LARGETEAU, Alain, 33610 Cestas (FR); U-CHAN CHUNG, Seu, 33400 Talence (FR); LE PETITCORPS, Yann, 33850 Leognan (FR); ROGER, Jérôme, 33600 Pessac (FR)
(74) Mandataire: Brevalex
(86) Numéro de dépôt international: PCT/EP2016/076555
(87) Numéro de publication internationale: WO 2017/076971

(56) Documents cités:
- DE-A1- 3 602 634
- FR-A1- 2 525 207
- JP-A- H09 157 073
- US-A1- 2009 224 434

## Description

### DOMAINE TECHNIQUE

L'invention a trait à une matrice et à un piston d'un appareil de frittage à chaud avec champ électrique pulsé (« *Spark Plasma Sintering* » ou SPS en anglais) qui permettent d'utiliser cet appareil sous une atmosphère oxydante, notamment sous air et à une température élevée, par exemple supérieure à 700°C, et pouvant atteindre par exemple jusqu'à 1450°C.

L'invention a trait en outre à un appareil de SPS comprenant cette matrice et ce piston, ou plus exactement à un appareil de SPS comprenant une chambre de frittage, densification ou assemblage, constituée par ladite matrice et par deux desdits pistons.

L'invention concerne enfin un procédé de frittage, densification, ou assemblage par SPS sous une atmosphère oxydante, notamment sous air, et à une température élevée par exemple supérieure à 700°C, et pouvant atteindre jusqu'à 1450°C, qui utilise ledit appareil.

Le domaine technique de l'invention peut être défini, de manière générale, comme celui du frittage, de la densification, ou de l'assemblage par la technique de SPS.

### ÉTAT DE LA TECHNIQUE ANTÉRIEURE

La technologie du frittage à chaud avec champ électrique pulsé, ou frittage (ou densification) sous courant électrique pulsé (« *Spark Plasma Sintering* » ou « SPS » en anglais) est aussi connue sous les dénominations anglaise, de « *Field Activated Sintering »* ou FAS, « *Field Activated Sintering Technique* » ou FAST, ou encore de « *Pulsed Electric Current Sintering* » ou PECS.

Les premières demandes de brevet [1], [2] concernant cette technologie ont été déposées par K. INOUE à la fin des années 1960.

Mais il a fallu attendre la fin des années 1990 pour que le nombre de brevets et publications concernant la technique de « SPS » augmente de manière exponentielle. En Europe, le nombre de machines de « SPS » n'a réellement augmenté qu'au début des années 2000.

Le « SPS » est une technique de frittage qui consiste à appliquer simultanément sur l'échantillon massif ou pulvérulent à densifier, ou sur les pièces à assembler une pression uniaxiale et des impulsions (« *pulses* ») de courant électrique de forte intensité qui provoquent une montée en température de l'échantillon.

Le courant est appliqué sous la forme de trains d'impulsions de courant, par exemple d'une période de 3,3 ms, dont l'intensité peut atteindre plusieurs milliers d'ampères, par exemple jusqu'à 8000 A, voire 50000 A.

Les poudres ou pièces peuvent être en matériaux métalliques, céramiques, ou polymères.

Le courant électrique est appliqué à l'échantillon par l'intermédiaire d'un montage, assemblage, de plateaux ou espaceurs (« *spacers* » en anglais) et de pistons, généralement en graphite, la poudre est insérée à l'intérieur d'une pastilleuse, appelée aussi matrice ou chemise (« *die* » en anglais), généralement en graphite, entre deux pistons.

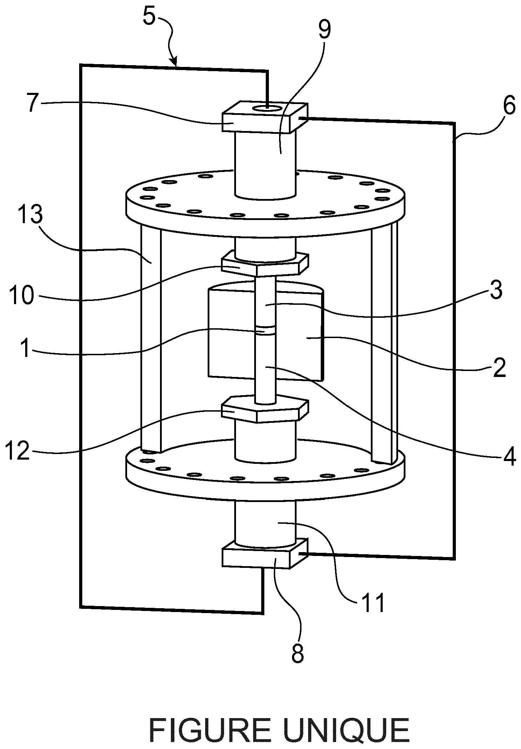

Plus exactement, on a représenté sur la Figure unique le principe de fonctionnement d'un appareil de SPS et ses principaux organes. La poudre à fritter est placée dans une chambre (1) qui est définie à l'intérieur d'une matrice (« *die* » en anglais) ou chemise, par exemple en graphite (2), entre un piston (« *punch* » en anglais) supérieur (3) et un piston inférieur (4). Plus exactement, la chambre (1) se trouve dans la matrice (2) entre l'extrémité supérieure du piston inférieur (4) et l'extrémité inférieure du piston supérieur (3).

Les pistons sont généralement en graphite.

Une pression (5) est appliquée à ces pistons (3, 4), et un courant continu (6) est appliqué à des électrodes supérieure (7) et inférieure (8). La pression et le courant appliqués respectivement à l'électrode supérieure (7) et à l'électrode inférieure (8) sont transmis respectivement au piston supérieur (3) et au piston inférieur (4) par l'intermédiaire d'espaceurs, ou plateaux, ou disques, supérieurs (9, 10) et inférieurs (11, 12) également généralement en graphite.

La poudre (1), les pistons (3, 4), la matrice ou chemise en graphite (2) et une portion des espaceurs (9, 11) sont placés à l'intérieur d'une enceinte sous vide (13).

En lieu et place de la poudre à fritter, on peut placer dans la chambre (1) entre les deux pistons (3, 4) une pièce, par exemple en céramique, à densifier, ou bien deux pièces par exemple en céramique à assembler de façon à avoir dans la matrice la succession piston-lère pièce, par exemple en céramique-2^{ème} pièce, par exemple en céramique-piston.

Le montage, assemblage, constitué par la pastilleuse, matrice, les pistons et les espaceurs, plateaux est le seul, dans l'enceinte sous vide, à monter en température.

La température est généralement suivie par l'intermédiaire d'un pyromètre optique qui pilote également la puissance électrique injectée dans le montage. Comme on l'a déjà mentionné plus haut, les courants utilisés lors du frittage peuvent aller jusqu'à 50000 A.

Le principal intérêt de la technologie « SPS » est la possibilité de densifier des échantillons, mêmes très réfractaires, tels que des céramiques, en des temps très courts de l'ordre de quelques minutes, par exemple de 5 à 10 minutes.

La rapidité de frittage permet souvent de minimiser la croissance de grains et d'atteindre pour certains matériaux une densité proche de 100%.

Classiquement, les appareils de SPS fonctionnent sous vide.

Dans ces montages classiques sous vide, tel que celui représenté sur la Figure unique, l'utilisation de matrices et de pistons en graphite (et aussi d'espaceurs, plateaux, disques en graphite) est particulièrement adaptée.

Toutefois il existe également des travaux menés sous atmosphère neutre. Mais dans tous les cas, cela mène à une très faible pression partielle d'oxygène à l'intérieur de la chambre.

Dans tous les cas, les frittages ont donc lieu en atmosphère neutre ou sous vide, sinon, le graphite s'oxydant à basse température (400°C), la matrice, et les pistons se détérioreraient très rapidement.

Cependant, il existe de nombreux domaines où il serait très intéressant de réaliser un frittage par SPS dans une atmosphère oxydante, notamment dans l'air.

Ainsi, par exemple, le frittage sous air par SPS apparaît comme une technique de densification susceptible de constituer une alternative aux techniques de densification actuellement utilisées (par exemple le frittage libre sous air) pour la densification de tous les matériaux oxydes, comme par exemple le TiO₂, Al₂O₃ ou bien, par exemple, les structures pérovskites de type Ca_{0.9}Yb_{0.1}MnO₃₋ₓ pour l'élaboration de matériaux thermoélectriques [3].

En effet d'une manière générale, les propriétés de transport des oxydes sont très dépendantes des lacunes en oxygène dans leur structure atomique.

Par conséquent, la maîtrise de ces lacunes en oxygène lors du frittage par SPS est capitale pour les propriétés finales du matériau. En réalisant le frittage par SPS sous une atmosphère oxydante, par exemple air sous air, on éviterait la réduction des oxydes, et on maîtriserait bien les lacunes en oxygène. Ceci confirme qu'il serait très intéressant de de réaliser un frittage par SPS dans une atmosphère oxydante, notamment dans l'air.

Cependant, le frittage par SPS dans une atmosphère oxydante, notamment dans l'air ne peut être réalisé dans les appareils de SPS classiques, actuels, car ces appareils comportent des matrices et pistons en graphite qui se dégradent très vite sous une atmosphère oxydante et à des températures relativement basses, par exemple dès 400°C. En d'autres termes, le graphite est absolument proscrit dans les appareils de SPS fonctionnant sous une atmosphère oxydante, notamment sous air.

Un seul document, à savoir le document [3], porte sur la possibilité d'utiliser la technique de SPS sous air et propose, pour constituer la matrice de l'appareil de SPS, des matériaux susceptibles de remplacer le graphite.

Plus exactement, le document [3] s'intéresse au frittage du Ca_{0.9}Yb_{0.1}MnO₃₋ₓ par la technique de SPS et compare :
i) le frittage par la technique de SPS classique c'est-à-dire avec un appareil comprenant une matrice en graphite, le frittage étant réalisé sous vide à 900°C ;
ii) le frittage par la technique de SPS, avec un appareil comprenant une matrice en carbure de tungstène WC, le frittage étant réalisé sous air à une température pouvant aller jusqu'à 600°C ;
iii) le frittage par la technique de SPS, avec un appareil comprenant un moule en alliage métallique (Inconel 718), le frittage étant réalisé sous air à une température pouvant aller jusqu'à 700°C.

Il y a lieu de noter que les matériaux destinés à constituer les matrices des appareils de SPS doivent présenter trois caractéristiques fondamentales à savoir : ils doivent être conducteurs du courant électrique, résister à l'oxydation à la température de travail, par exemple jusqu'à 1450°C, et garder de bonnes propriétés mécaniques pour pouvoir transmettre la pression.

Parmi les matériaux qui constituent les matrices des appareils de SPS dans le document [3], aussi bien le carbure de tungstène WC que l'Inconel 718 sont conducteurs, en revanche le carbure de tungstène WC s'oxyde très rapidement dès 500-600°C ce qui ne permet pas de l'utiliser au-delà, et l'Inconel 718 perd ses propriétés mécaniques au-delà de 600°C. Par conséquent, ces matériaux ne pourraient pas être utilisés pour des températures dépassant les 700-800°C.

Le document [4] décrit un outillage, appareil classique qui comporte une matrice et des pistons en SiC monolithique.

Mais, comme le SiC monolithique n'est que semi-conducteur, il est obligatoire de le doubler d'une chambre en graphite pour permettre le passage des impulsions de courant.

Un appareil ainsi conçu, avec donc un doublage en graphite, permet d'atteindre de plus hautes pressions que l'appareil classique présenté dans le document [4]. En revanche, il ne permet pas de travailler sous air à cause de la présence du graphite.

Un tel appareil est à l'heure actuelle commercialisé pour une utilisation mais seulement sous vide ou sous gaz neutre à une plus haute pression que les appareils classiques.

Le document [5] mentionne un appareil de frittage à chaud avec champ électrique pulse SPS qui contient une matrice en graphite est des pistons en graphite. La matrice et les pistons sont protégés par des feuilles en carbone. Par l'utilisation de ces feuilles il est plus facile de quitter la céramique après frittage.

Il ressort de ce qui précède, qu'il existe un besoin pour un appareil de SPS, et un procédé de SPS utilisant cet appareil, qui permettent de fritter, densifier, ou assembler des poudres ou pièces, sous une atmosphère oxydante, notamment sous une atmosphère d'air, et à une température élevée, par exemple supérieure ou égale à 700°C ou 800°C et cela sans que l'appareil de SPS et notamment la matrice et les pistons de celui-ci ne soient dégradés ou détériorés même après plusieurs opérations de frittage, densification ou assemblage.

Le but de la présente invention est entre autres de répondre à ces besoins.

Le but de la présente invention est encore de fournir un tel appareil et un tel procédé qui ne présentent pas les inconvénients, défauts, limitations et désavantages des procédés et appareils de l'art antérieur et qui résolvent les problèmes des procédés et appareils de l'art antérieur.

Le but de la présente invention est aussi de surmonter ces inconvénients et d'apporter une solution à ces problèmes en modifiant un minimum d'éléments dans les appareils de SPS existant.

### EXPOSÉ DE L'INVENTION

Ce but, et d'autres encore, sont atteints selon l'invention, tout d'abord en fournissant une matrice d'appareil de frittage à chaud avec champ électrique pulsé, caractérisée en ce que ladite matrice est en graphite et les surfaces externes de ladite matrice sont revêtues par une couche en carbure de silicium d'une épaisseur de 1 à 10 µm, ladite couche en carbure de silicium étant en outre éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

Dans le cas où les surfaces externes de la matrice sont revêtues, outre par la couche en carbure de silicium par une ou plusieurs autres couches en un carbure autre que le carbure de silicium, la première couche qui revêt lesdites surfaces externes, est toujours une couche en SiC car cette couche présente les meilleures propriétés de protection contre l'oxydation.

Autrement dit, dans le cas où les surfaces externes de la matrice sont revêtues de plusieurs couches, formant ainsi un revêtement multicouche, alors la couche de ce revêtement multicouche la plus proche desdites surfaces externes est une couche en carbure de silicium.

Ce but et d'autres encore sont atteints selon l'invention également en fournissant un piston d'appareil de frittage à chaud avec champ électrique pulsé, caractérisé en ce que ledit piston est en graphite et les surfaces externes dudit piston sont revêtues par une couche en carbure de silicium d'une épaisseur de 1 à 10 µm, ladite couche en carbure de silicium étant en outre éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

Dans le cas où les surfaces externes du piston sont revêtues outre par la couche en carbure de silicium par une ou plusieurs autres couches en un carbure autre que le carbure de silicium, la première couche qui revêt lesdites surfaces externes, est toujours une couche en SiC car cette couche présente les meilleures propriétés de protection contre l'oxydation.

Autrement dit, dans le cas où les surfaces externes du piston sont revêtues de plusieurs couches, formant ainsi un revêtement multicouche, alors la couche de ce revêtement multicouche la plus proche desdites surfaces externes est une couche en carbure de silicium.

La matrice et le piston d'appareil de frittage à chaud avec champ électrique pulsé SPS selon l'invention se distinguent fondamentalement des matrices et pistons d'appareil de frittage à chaud avec champ électrique pulsé SPS, classiques, de l'art antérieur. En effet, les matrices et pistons de l'art antérieur sont constitués uniquement par du graphite alors que la matrice et le piston selon l'invention sont, certes, en graphite mais les surfaces externes de ladite matrice et dudit piston sont revêtues d'une couche en carbure de silicium d'une épaisseur spécifique.

Ladite couche en carbure de silicium est en outre éventuellement revêtue par une ou plusieurs autre(s) couche(s) en un carbure autre que le carbure de silicium choisi parmi le carbure de hafnium, le carbure de tantale et le carbure de titane, chacune de cette ou de ces autre(s) couche(s) ayant aussi une épaisseur spécifique.

Une matrice et un piston d'appareil de frittage à chaud avec champ électrique pulsé, en graphite, dont les surfaces externes sont revêtues d'une couche en carbure de silicium d'une épaisseur spécifique de 1 à 10 µm ne sont ni décrits, ni suggérés dans l'art antérieur.

A fortiori, une matrice et un piston d'appareil de frittage à chaud avec champ électrique pulsé, en graphite, dont les surfaces externes sont revêtues d'une couche en carbure de silicium SiC d'une épaisseur spécifique de 1 à 10 µm, ladite couche en SiC étant en outre revêtue par une ou plusieurs autre(s) couche(s) en un carbure autre que le carbure de silicium choisi parmi le carbure de hafnium, le carbure de tantale et le carbure de titane, chacune de cette ou de ces autres(s) couche(s) ayant aussi une épaisseur spécifique de 1 à 10 µm, ne sont ni décrits, ni suggérés dans l'art antérieur.

La matrice et le piston selon l'invention associent donc un cœur en graphite avec une enveloppe, couche de surface en SiC, ladite couche en carbure de silicium étant en outre éventuellement revêtue par une ou plusieurs autre(s) couche(s) en un carbure autre que le carbure de silicium

Ainsi, dans la matrice et le piston selon l'invention, on bénéficie des propriétés de protection contre l'oxydation lors d'un fonctionnement de l'appareil de SPS sous une atmosphère oxydante, qui sont conférées par la couche en SiC, dont sont pourvues les surfaces externes de la pièce selon l'invention tout en conservant les propriétés conductrices du graphite indispensables pour la SiC.

Autrement dit, la couche en SiC constitue un revêtement de protection contre l'oxydation (PAO) qui protège le graphite lors d'un fonctionnement de l'appareil de SPS sous une atmosphère oxydante et permet de manière étonnante d'utiliser une matrice et des pistons essentiellement constitués par du graphite, avec ses indispensable propriétés conductrices de l'électricité, alors que cela était absolument proscrit dans l'art antérieur.

Un préjugé est ainsi surmonté par la matrice et le piston selon l'invention.

Le carbure de silicium (SiC) est très intéressant pour former des PAO notamment des PAO qui résistent à de hautes températures, par exemple supérieures à 800°C, car il forme, avec l'oxygène de l'air, un oxyde qui, au-delà de 1300°C, a la plus faible perméabilité à l'oxygène de tous les oxydes. De plus, dans certaines conditions de température et de pression partielle d'O₂, il forme une phase vitreuse qui permet en nappant le carbone de boucher les pores et les fissures éventuelles.

Selon l'invention, le revêtement en SiC sur les pièces en graphite d'un appareil de SPS qui sont les plus sollicitées à température élevée, c'est-à-dire la matrice et les pistons permet de manière étonnante de réaliser un frittage sous une atmosphère oxydante, notamment sous air sans dégradation de ces pièces et même à une température élevée supérieure ou égale à 700°C, ce qui n'était pas possible dans l'art antérieur.

Le piston et la matrice selon l'invention présentent les trois caractéristiques fondamentales énoncées plus haut que doivent posséder ces pièces, à savoir : ils sont conducteurs du courant électrique, ils résistent à l'oxydation à la température de travail, par exemple au-dessus de 700°C et jusqu'à 1450°C, et ils gardent de bonnes propriétés mécaniques pour pouvoir transmettre la pression.

Le piston et la matrice selon l'invention peuvent être facilement, rapidement, et simplement préparés à faible coût, en effet, il suffit par exemple de revêtir d'une couche en SiC (ladite couche en carbure de silicium étant en outre éventuellement revêtue par une ou plusieurs autre(s) couche(s) en un carbure autre que le carbure de silicium) la matrice et les pistons classiques en graphite d'un appareil classique, pour obtenir le piston et la matrice selon l'invention.

Ainsi, moyennant des changements minimes, simples, rapides, et peu coûteux, apportés à des pistons et matrices classiques en graphite, et à l'appareil les comprenant, on obtient des avantages considérables lors de la mise en œuvre du procédé de SPS.

Avantageusement, les surfaces externes de ladite matrice sont revêtues d'une couche en carbure de silicium par un procédé de dépôt chimique en phase vapeur « CVD », et ladite couche en carbure de silicium est en outre éventuellement revêtue par une ou plusieurs autre(s) couche(s) en un carbure autre que le carbure de silicium choisi parmi le carbure de hafnium, le carbure de tantale et le carbure de titane, par un procédé de dépôt chimique en phase vapeur « CVD ».

Avantageusement, les surfaces externes dudit piston sont revêtues d'une couche en carbure de silicium par un procédé de dépôt chimique en phase vapeur « CVD », et ladite couche en carbure de silicium est en outre éventuellement revêtue par une ou plusieurs autre(s) couche(s) en un carbure autre que le carbure de silicium choisi parmi le carbure de hafnium, le carbure de tantale et le carbure de titane, par un procédé de dépôt chimique en phase vapeur « CVD ».

Le procédé de dépôt chimique en phase vapeur est préféré pour déposer la couche en carbure de silicium et éventuellement la ou les autre(s) couche(s) car il présente le double avantage d'être rapide et peu onéreux.

Le but de la présente invention et d'autres encore sont ensuite atteints en fournissant un appareil de frittage à chaud avec champ électrique pulsé SPS comprenant une matrice et deux pistons, définissant une chambre de frittage, densification ou assemblage capable de recevoir une poudre à fritter, une pièce à densifier, ou des pièces à assembler caractérisé en ce que ladite matrice est une matrice selon l'invention telle que décrite plus haut, et lesdits pistons sont des pistons selon l'invention tels que décrits plus haut.

L'appareil selon l'invention se différencie des appareils de l'art antérieur seulement par le fait qu'il comprend la matrice et les pistons selon l'invention, revêtus d'une couche en SiC (ladite couche en carbure de silicium étant en outre éventuellement revêtue par une ou plusieurs autre(s) couche(s) en un carbure autre que le carbure de silicium), en lieu et place de la matrice et des pistons classiques, de l'art antérieur, intégralement en graphite. La modification à apporter aux appareils existant est donc minime et le remplacement de la matrice et des pistons classiques par la matrice et les pistons selon l'invention peut se faire facilement, simplement, rapidement et à un faible coût.

L'appareil selon l'invention présente tous les effets surprenants et avantages dus de manière inhérente à la matrice et aux pistons selon l'invention que cet appareil comprend. La plupart de ces effets surprenant et avantages ont déjà été exposés plus haut.

L'invention concerne, en outre, un procédé de frittage d'une poudre, densification d'une pièce, ou assemblage de deux pièces par un procédé de frittage à chaud avec champ électrique pulsé SPS dans une atmosphère oxydante, caractérisé en ce que ledit procédé utilise l'appareil de frittage à chaud avec un champ électrique pulsé SPS tel qu'il a été décrit plus haut.

Le procédé selon l'invention se différencie des procédés de l'art antérieur en ce que ledit procédé utilise l'appareil de frittage à chaud avec champ électrique pulsé SPS selon l'invention qui comprend la matrice et les pistons selon l'invention, revêtus d'une couche en SiC (ladite couche en carbure de silicium étant en outre éventuellement revêtue par une ou plusieurs autre(s) couche(s) en un carbure autre que le carbure de silicium), en lieu et place de la matrice et des pistons classiques, de l'art antérieur, intégralement en graphite.

Le procédé selon l'invention présente tous les effets surprenants et avantages dus de manière inhérente à l'utilisation de l'appareil selon l'invention, comprenant, la matrice et les pistons selon l'invention. La plupart de ces effets surprenant et avantages ont déjà été exposés plus haut.

En particulier, le procédé selon l'invention grâce à l'appareil comprenant la matrice et les pistons selon l'invention qu'il utilise permet pour la première fois de pouvoir mettre en œuvre le procédé de SPS avec succès sous une atmosphère oxydante telle que de l'air, à des températures élevées pouvant atteindre par exemple jusqu'à 1450°C. On le montre dans les exemples fournis plus loin.

Par rapport à un procédé de SPS classique utilisant un appareil de SPS classique avec une matrice et des pistons en graphite non revêtu, les paramètres du procédé ne sont que peu modifiés, alors que les avantages obtenus sont très importants.

Avantageusement, l'atmosphère oxydante est choisie parmi les atmosphères de gaz contenant de l'oxygène, comme l'oxygène (pur), l'air, tel que l'air ambiant, et l'air enrichi en oxygène.

Cette atmosphère est celle qui règne dans l'enceinte (13) de l'appareil de SPS tel que décrit plus haut.

Cette enceinte n'étant plus sous vide, l'appareil se trouve simplifié et des économies importantes sont en outre ainsi réalisées.

Avantageusement lors du procédé de frittage à chaud avec champ électrique pulsé SPS, on applique un courant électrique pulsé suffisant à la poudre, à la pièce, ou aux pièces, pour élever la température de la poudre, de la pièce, ou des pièces jusqu'à une température au moins égale à 700°C ou 800°C, de préférence de 700°C ou 800 °C à 2500°C, de préférence encore de 700°C ou 800°C à 1450°C, mieux de de 900°C à 1450°C, mieux encore de 1100°C à 1450°C.

Avantageusement, à l'issue du frittage de la poudre, de la densification de la pièce, ou de l'assemblage des deux pièces par le procédé de frittage à chaud avec champ électrique pulsé SPS, on refroidit la poudre frittée, la pièce densifiée, ou l'assemblage des deux pièces, de préférence jusqu'à la température ambiante, et on récupère la poudre frittée refroidie, la pièce densifiée refroidie, ou l'assemblage des deux pièces refroidi.

La poudre à fritter, la pièce à densifier, ou les pièces à assembler peuvent être en un matériau choisi parmi les métaux, les alliages de métaux, les oxydes de métaux ou de métalloïdes y compris les oxydes mixtes de métaux ou de métalloïdes, les carbures de métaux ou de métalloïdes, les nitrures de métaux ou de métalloïdes, et leurs mélanges.

Avantageusement, on peut réaliser le frittage d'une poudre d'un oxyde de métal ou de métalloïde ou d'un mélange de poudres d'oxydes de métal ou de métalloïde.

Avantageusement, le ou les oxyde(s) de métal ou de métalloïde est (sont) choisi(s) parmi le TiO₂, l'Al₂O₃, le BaTiO₃, et les pérovskites, par exemple de formule Ca_{0,9} Yb_{0,1}MnO₃₋ₓ.

Le frittage, la densification, ou l'assemblage sous air présentent de nombreux avantages qui ont déjà été évoqués plus haut.

Fritter sous air permet de contrôler la stœchiométrie en oxygène des matériaux frittés, notamment des oxydes. Cela permet de maîtriser non seulement leurs propriétés électriques, mais aussi toutes leurs autres propriétés, comme les propriétés, magnétique, diélectrique, etc.

En effet, toutes ces propriétés dépendent de cette stœchiométrie en oxygène.

Les exemples fournis plus bas réalisés à des températures de 900°C, 1100°C et 1450°C sous air montrent que le procédé selon l'invention a été effectivement mis en œuvre avec succès.

D'autres caractéristiques et avantages de l'invention apparaîtront mieux à la lecture de la description détaillée qui suit, cette description étant faite à titre illustratif et non limitatif, en liaison avec le dessin joint.

### BRÈVE DESCRIPTION DU DESSIN

- La Figure unique est un vue schématique en coupe verticale d'un exemple d'appareil de SPS classique, ou d'un exemple d'appareil de SPS selon l'invention comprenant une matrice et des pistons selon l'invention.

### EXPOSÉ DÉTAILLÉ DE MODES DE RÉALISATION PARTICULIERS

Dans la description qui suit de la matrice, du piston, de l'appareil, et du procédé selon l'invention, on fait référence à la Figure unique.

L'appareil montré sur la Figure unique peut être aussi bien un appareil classique comprenant une matrice et des pistons classiques, par exemple en graphite, qu'un appareil selon l'invention comprenant une matrice et des pistons selon l'invention dont les surfaces sont revêtues d'une couche en carbure de silicium (ladite couche en carbure de silicium étant en outre éventuellement revêtue par une ou plusieurs autre(s) couche(s) en un carbure autre que le carbure de silicium).

En effet selon l'invention, il suffit simplement, de remplacer les pistons et la matrice, généralement en graphite, d'un appareil classique, tel qu'un appareil actuellement commercialisé, la matrice et les pistons selon l'invention pour obtenir un appareil selon l'invention et tous les effets avantageux de l'invention. Un tel changement de matrice et de pistons est le changement est rapide, facile, et d'un faible coût.

La modification ainsi apportée à un appareil classique pour obtenir un appareil selon l'invention est donc minime et apporte des avantages importants.

On peut même retirer la matrice et les pistons en graphite d'un appareil classique, les revêtir d'une couche en SiC, et éventuellement d'une ou plusieurs autre(s) couche(s) en un carbure autre que le carbure de silicium, puis les replacer dans l'appareil.

En outre l'enceinte (13) représentée sur la Figure unique n'est pas dans le cas d'un appareil de SPS selon l'invention, placée sous vide, mais sous une atmosphère oxydante, notamment sous air, par exemple tout simplement sous air ambiant.

On commence par décrire une matrice (2) d'appareil de frittage à chaud avec champ électrique pulsé selon l'invention.

Conformément à l'invention, cette matrice (2) est en graphite et les surfaces externes de ladite matrice sont revêtues d'une couche en carbure de silicium d'une épaisseur de 1 à 10 µm, ladite couche en carbure de silicium étant éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

Cette matrice (2) peut être aussi appelée moule, chemise, matrice, ou pastilleuse et présente généralement une forme de tube ou cylindre creux comme celle représentée sur la Figure unique.

Cette matrice possède la même forme et les mêmes dimensions qu'une matrice d'appareil de SPS classique à la différence essentielle toutefois que selon l'invention, les surfaces externes de ladite matrice sont revêtues d'une couche en carbure de silicium, et en outre éventuellement par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

On décrit ensuite un piston d'appareil de frittage à chaud avec champ électrique pulsé selon l'invention. Ce piston peut être aussi bien le piston supérieur (3) que le piston inférieur (4) montré sur la Figure unique.

Conformément à l'invention, ce piston (3, 4) est en graphite et les surfaces externes dudit piston sont revêtues d'une couche en carbure de silicium homogène d'une épaisseur de 1 à 10 µm, ladite couche en carbure de silicium étant éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

Ce piston (3, 4) présente généralement une forme de cylindre plein comme celle représentée sur la Figure unique.

Ce piston possède la même forme et les mêmes dimensions qu'un piston d'appareil de SPS classique à la différence essentielle toutefois que selon l'invention, les surfaces externes dudit piston sont revêtues d'une couche en carbure de silicium, ladite couche en carbure de silicium étant éventuellement revêtue par une ou plusieurs autre(s) couche(s) en un carbure autre que le carbure de silicium choisi parmi le carbure de hafnium, le carbure de tantale et le carbure de titane.

Selon l'invention, la couche en carbure de silicium est une couche que l'on peut qualifier de couche très fine ou très mince. Selon l'invention, on entend généralement par couche très fine ou très mince une couche d'une épaisseur de 1 µm à 10 µm.

La couche en carbure de silicium peut être déposée sur les surfaces externes de la matrice et du piston en graphite partout procédé adéquat connu de l'homme du métier.

De la même manière, la ou les autre(s) couche(s) en un carbure autre que le carbure de silicium choisi parmi le carbure de hafnium, le carbure de tantale et le carbure de titane, peuvent être déposées par tout procédé adéquat connu de l'homme du métier.

La matrice et le piston qui sont ainsi revêtus peuvent être une matrice et un piston classique en graphite, disponibles dans le commerce. Comme on l'a déjà indiqué plus haut, on peut par exemple retirer les appareils et les pistons en graphite d'un appareil classique et les revêtir d'une couche en SiC, ladite couche en carbure de silicium étant éventuellement revêtue en outre par une ou plusieurs autre(s) couche(s) en un carbure autre que le carbure de silicium, avant de les replacer dans l'appareil.

Un procédé préféré est le procédé de dépôt chimique en phase vapeur (« *Chemical Vapeur Déposition* » ou « *CVD* » en anglais).

L'homme du métier sait comment choisir les paramètres du procédé de CVD, à savoir notamment le précurseur, la température de dépôt, les débits de gaz (par exemple précurseur et hydrogène), et la durée du procédé pour obtenir sur un piston ou une matrice en graphite une couche en SiC de l'épaisseur souhaitée.

De même, l'homme du métier sait comment choisir les paramètres du procédé de CVD, à savoir notamment le précurseur, la température de dépôt, les débits de gaz (par exemple précurseur et hydrogène), et la durée du procédé pour obtenir sur un piston ou une matrice en graphite une couche en HfC, TiC ou TaC de l'épaisseur souhaitée.

Les paramètres du procédé de dépôt chimique en phase vapeur, généralement réalisé dans un four de dépôt chimique en phase vapeur CVD peuvent, à titre d'exemple, être les suivants pour le dépôt de la couche en SiC :
- Précurseur utilisé : MTS (méthyltrichlorosilane),
- Température du dépôt : 900°C à 1200°C, par exemple 975°C;
- Débit d'hydrogène : 300 à 600 sccm, par exemple 450 sccm (« *standard cubic centimers per minute* » en anglais c'est-à-dire centimètres cubes standards par minute) ;
- Débit de MTS : 50 à 250 sccm, par exemple 150 sccm ;
- Durée du traitement : 0,5 heures à 5 heures, par exemple 2,5 heures.
- Epaisseur du dépôt : 1 à 10 µm.

On peut facilement faire varier l'épaisseur du dépôt, par exemple en augmentant la durée du dépôt à une température donnée.

Les paramètres du procédé de dépôt chimique en phase vapeur qui sont donnés ci-dessus, le sont à titre indicatif, à titre d'exemple et ne sont donc absolument pas limitatifs.

On décrit maintenant un appareil de frittage à chaud avec champ électrique pulsé SPS selon l'invention.

L'appareil de SPS selon l'invention comprend une matrice (2) et deux pistons (3, 4), définissant une chambre de frittage, densification ou assemblage (1) capable de recevoir une poudre à fritter, une pièce à densifier ou des pièces à assembler, ladite matrice (2) étant une matrice selon l'invention et lesdits pistons (3, 4) étant des pistons selon l'invention.

Comme on l'a indiqué plus haut, la description d'un appareil de SPS déjà effectuée plus haut en relation avec la Figure unique jointe s'applique aussi intégralement à l'appareil selon l'invention.

Toutefois l'appareil selon l'invention comprend une matrice et des pistons selon l'invention qui sont une matrice et des pistons en graphite dont les surfaces sont revêtues d'une couche en carbure de silicium, éventuellement revêtue par une ou plusieurs autre(s) couche(s) en un carbure autre que le carbure de silicium, et non une matrice et des pistons classiques en graphite, non revêtus.

Eventuellement, dans l'appareil selon l'invention les espaceurs, plateaux, disques, s'ils sont en graphite, peuvent, tout comme la matrice et les pistons, être revêtus d'une couche en carbure de silicium d'une épaisseur de 1 à 10 µm, ladite couche en carbure de silicium étant en outre éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

Toutefois il est moins crucial de revêtir les espaceurs plateaux, disques d'une couche en carbure de silicium et éventuellement d'une ou plusieurs autre(s) couche(s) en un carbure autre que le carbure de silicium car la température des espaceurs, plateaux et disques s'élève moins que la température de la matrice et des pistons. En effet, la température des espaceurs, plateaux et disques ne s'élève au maximum qu'à environ 300°C à 400°C, température à laquelle le graphite ne s'oxyde pas.

En outre, comme précisé plus haut, l'enceinte (13) représentée sur la Figure unique, n'est pas obligatoirement, dans le cas d'un appareil de SPS selon l'invention, placée sous vide.

On décrit maintenant le procédé selon l'invention de frittage d'une poudre, densification d'une pièce, ou assemblage de deux pièces par un procédé de frittage à chaud avec champ électrique pulsé SPS qui, utilise l'appareil selon l'invention.

La description qui suit est donnée en relation avec le frittage d'une poudre ou d'un mélange de poudres, mais elle pourrait s'appliquer, moyennant quelques adaptations à la portée de l'homme du métier à la densification d'une pièce, ou à l'assemblage de deux pièces.

La poudre ou les poudres à fritter, peuvent être en un matériau choisi parmi les métaux, les alliages de métaux, les oxydes de métaux ou de métalloïdes y compris les oxydes mixtes de métaux ou de métalloïdes, les carbures de métaux ou de métalloïdes, et les nitrures de métaux ou de métalloïdes.

Avantageusement, on peut réaliser le frittage d'une poudre d'un oxyde de métal ou de métalloïde ou d'un mélange de poudres d'oxydes de métal ou de métalloïde.

Avantageusement, le ou les oxyde(s) de métal ou de métalloïde est (sont) choisi(s) parmi le TiO₂, l'Al₂O₃, le BaTiO₃, et les pérovskites, par exemple de formule Ca_{0,9}Yb_{0,1}MnO₃₋ₓ.

On commence généralement par placer la poudre ou le mélange de poudres à l'intérieur du moule, de la pastilleuse, chemise, matrice en graphite revêtu de SiC de l'appareil, machine, dispositif de « SPS », selon l'invention, décrit plus haut.

Généralement, on place une feuille de graphite souple tel que le produit commercialisé sous la dénomination commerciale de PAPYEX® par la société Carbone Lorraine entre la poudre ou le mélange de poudres et les parois internes du moule et entre la poudre ou le mélange de poudres et les pistons. Cette feuille a pour but d'empêcher la ou les poudre(s) de réagir avec le moule et les pistons et de les préserver.

Le PAPYEX® peut être revêtu sur une de ses faces, à savoir la face en contact avec la poudre ou le mélange de poudres, d'une couche de nitrure de bore BN.

Le BN joue le rôle de barrière de diffusion entre la ou les poudre(s) et le graphite.

Selon l'invention, la feuille de graphite souple, PAPYEX® peut être omise, car le SiC dont sont revêtus la matrice et les pistons, permet aussi de bloquer la diffusion du carbone provenant de la matrice et des pistons vers le matériau à fritter. Il s'agit là d'un avantage supplémentaire apporté par la matrice et les pistons selon l'invention par rapport aux matrices et pistons de l'art antérieur en graphite pur, non revêtu de SiC.

Le moule en graphite revêtu de SiC peut être également recouvert d'un feutre en graphite pour limiter le rayonnement.

La pastilleuse, matrice, chemise, moule et les pistons sont ensuite placés dans la machine de SPS telle que la machine décrite sur la Figure unique.

Conformément à l'invention, l'enceinte (13) n'est pas mise sous vide, mais est placée sous une atmosphère oxydante.

Cette atmosphère peut être notamment une atmosphère d'oxygène (pur), d'air ou encore d'air enrichi en oxygène.

Tout simplement l'enceinte (13) peut rester sous air ambiant.

Il est à noter que dans le procédé selon l'invention utilisant l'appareil de SPS selon l'invention, peu de paramètres parmi les paramètres qui régissent le procédé de frittage, densification, ou assemblage, sont modifiés par rapport à un procédé classique utilisant un appareil classique de SPS avec une matrice et des pistons non revêtus par une couche en SiC. La différence fondamentale entre un procédé classique et le procédé selon l'invention est que dans ce dernier, grâce à l'appareil spécifique qu'il met en œuvre, le frittage est réalisé sous une atmosphère oxydante.

On applique ensuite une pression suffisante audit mélange de poudres et simultanément, on applique un courant électrique pulsé suffisant à la poudre ou au mélange de poudres pour élever la température de la poudre ou du mélange de poudres jusqu'à une température suffisante pour provoquer un frittage de la poudre ou du mélange de poudres.

En d'autres termes, lorsque tout est en contact (matrice, pistons, mélange), on peut générer un courant électrique afin de créer l'élévation de température. De manière générale, l'ampérage maximal que peut supporter une matrice est lié notamment à son diamètre. Ainsi, pour un diamètre d'échantillon de 8 mm, on peut appliquer 2000 A sans risquer de détériorer la matrice. Pour des diamètres plus importants tels que 20 mm, on peut appliquer 4000 A ou plus.

Le courant électrique pulsé appliqué est généralement de 1A à 50000A afin de créer une élévation de température jusqu'à une température (température de palier) généralement au moins égale à 700°C ou 800°C, de préférence de 700°C ou 800°C à 2500°C, de préférence encore de 700°C ou 800°C à 1450°C, mieux de 900°C à 1450°C, mieux encore de 1100°C à 1450°C, par exemple de 900°C, 1100°C ou 1450°C.

La pression qui est appliquée en même temps correspond à une force appliquée de 0,01 MPa à 500 MPa.

De préférence, la pression appliquée est selon l'invention généralement de 1 à 200 MPa et l'intensité appliquée est de préférence de 500 à 8000 A. De préférence, la pression est de 10 à 150 MPa, de préférence encore de 20 à 100 MPa, par exemple de 40 MPa.

De préférence, l'intensité est de 200 à 6000 A, de préférence encore de 300 à 1000 A.

Les valeurs de pression et d'intensité sont choisies à l'intérieur des plages ci-dessus de façon à ce que la température de la poudre ou du mélange de poudres s'élève à une température (température de palier) permettant le frittage de la poudre ou du mélange de poudres.

Une telle température est au moins égale à 700°C ou 800°C, de préférence de 700°C ou 800 °C à 2500°C, de préférence encore de 700°C ou 800°C à 1450°C, mieux de 900°C à 1450°C, mieux encore de 1100°C à 1450°C, par exemple de 900°C, 1100°C ou 1450°C.

La durée pendant laquelle est maintenue ladite température (encore appelée température de palier) par exemple de 1450°C, durée que l'on peut nommer aussi durée ou temps de palier est une durée courte généralement de 0 à 10 minutes, de préférence de 0 à 7 minutes, par exemple de 3 ou 5 minutes.

Lorsque le temps de palier est égal à 0, cela signifie que l'on effectue une montée en température jusqu'à la température maximale et que l'on redescend à la température ambiante sans qu'un palier soit observé.

On notera que cette durée de palier est dans tous les cas très faible, au regard des autres méthodes de frittage.

De même, le temps de cycle hors refroidissement, et la durée globale, totale du cycle complet avec le refroidissement, sont réduits.

Ce temps de cycle est par exemple de 10 à 30 minutes, notamment de 20 à 22 minutes seulement, et la durée du cycle complet est d'environ une heure, ce qui constitue un autre avantage du procédé selon l'invention.

Il est généralement important de maîtriser la descente en température et en pression afin d'éviter la fissuration du matériau à savoir de la poudre frittée.

Le refroidissement du matériau est généralement effectué de manière pas trop brutale comme peut le comprendre l'homme du métier dans ce domaine de la technique. Ainsi, on observera généralement une vitesse de refroidissement de 1°C à 600°C par minute, par exemple de 10°C à 100°C/min depuis le palier de température.

Le refroidissement peut s'effectuer avec une seule rampe selon l'inertie thermique de la machine depuis la température de palier jusqu'à l'ambiante.

Ou bien, de préférence, le refroidissement est effectué par rampes successives de température présentant des pentes différentes, ainsi le refroidissement peut s'effectuer par exemple comme suit : 45°C/min de la température de palier à 600°C ; puis refroidissement selon l'inertie thermique de la machine de 600°C à l'ambiante.

Il est évident pour l'homme du métier que le cycle température-pression est à optimiser pour chaque type de poudre ou de mélange de poudres de précurseurs, mis en œuvre.

En revanche, quelles que soient les montées, les descentes ou les durées des paliers en température et en pression, la simultanéité (des variations) de la température et de la pression est indispensable au bon frittage de la poudre ou du mélange de poudres.

Avantageusement, les paramètres de température et donc d'intensité, et de pression (ou de force appliquée, la pression dépendant de la surface d'appui suivant la relation bien connue P = F/S) ne sont pas, depuis la température ambiante et une pression de 0 MPa, appliqués de manière brutale, instantanée, mais sont élevés de manière progressive depuis la température ambiante (généralement 20°C à 25°C) et une pression de 0 MPa.

Pour la température (régie par l'intensité), on réalisera ainsi de préférence une montée progressive avec une rampe, ou plusieurs rampes présentant éventuellement des pentes différentes, ces rampes étant éventuellement séparées par des paliers intermédiaires, pour arriver jusqu'à la température maximale mentionnée plus haut, encore appelée température de palier ou de frittage.

La ou lesdites rampe(s) de températures ont préférentiellement une pente de 50°C à 200°C/min, par exemple de 80°C/min. ou de 100°C/min.

Globalement, pour atteindre la température maximale, par exemple de 900°C, 1100°C ou 1400°C, on ajuste de préférence la montée en température des rampes pour être le plus proche possible d'une rampe à 80°C/minute ou 100°C/minute.

Selon l'invention, lors du frittage, on peut ainsi observer un premier palier à une première température puis un second palier ou palier final à la température maximale ou température de frittage.
- Le premier palier peut être réalisé à une température de 600°C, à 800°C, par exemple de 600°C, pendant une durée de 1 à 5 minutes, par exemple de 3 minutes ;
- Le second palier peut être réalisé à une température de 900°C à 1450°C, par exemple de 1100°C, pendant une durée de 0 à 20 minutes, par exemple de 5 minutes.

Pour la pression, on pourra, de la même manière, avantageusement réaliser une montée progressive avec une rampe, ou plusieurs rampes présentant éventuellement des pentes différentes, ces rampes étant éventuellement séparées par des paliers intermédiaires, pour arriver jusqu'à la pression maximale indiquée plus haut, encore appelée pression de palier ou de frittage.

La ou lesdites rampe(s) de pression ont généralement une pente de 1 MPa/min à 40 MPa/min, de préférence de 40 MPa/min.

La montée en température et la montée en pression qu'elles soient progressives ou non, se font de préférence de manière simultanée, concomitante, en une même durée.

Si plusieurs rampes de pression et plusieurs rampes de température sont réalisées, les rampes de pression et de température correspondantes ont de préférence la même durée.

En appliquant les paramètres de température (et donc d'intensité) et/ou de pression (et donc de force appliquée) de manière progressive et non de manière brutale, soudaine, instantanée, on évite ainsi de soumettre le matériau à des contraintes trop fortes et aucune cassure du matériau n'est à déplorer.

A titre d'exemple, une montée en température, depuis la température ambiante (généralement 20°C à 25°C), jusqu'à 1450°C, pourra s'effectuer de la manière suivante :
- de la température ambiante à 600°C : 4 minutes environ ;
- palier à 600°C : 1 minutes environ ;
- de 600°C à 1450°C : 8 minutes environ ;
- palier à 1450°C : 5 minutes environ ;
- refroidissement de 1450°C à la température ambiante : durée conditionnée par l'inertie thermique de la machine, par exemple de 10 minutes à 30 minutes, notamment 20 minutes.

Pendant le même temps, la pression évolue de la manière suivante :
- de 0 à 40 MPa, à partir du temps 0 (moment où le chauffage commence depuis la température ambiante, c'est-à-dire début de la première rampe de température) : 1 minute environ.
- palier à 40 MPa : 21 minutes environ.
- de 40 MPa à 0 MPa : 2 minutes environ.

Le courant est appliqué sous forme de séries, trains d'impulsions (« pulses ») ; chaque série, train, est constitué d'un nombre déterminé et réglable de « pulses ». Les séries (trains) sont séparées entre elles par un temps pendant lequel le courant appliqué est nul.

Dans le procédé selon l'invention, on utilise généralement des impulsions de 1 à 5 ms, par exemple de 3,3 ms de période, assemblées généralement par train de 1 à 15, par exemple 12 impulsions, chaque train étant généralement séparé par 1 à 15 périodes, par exemple 2 périodes, de la durée (telle que 3,3 ms) ci-dessus, sans courant.

Il est possible de changer ces valeurs mais le courant doit toujours garder la même géométrie, à savoir : des trains d'impulsions plus ou moins nombreux séparés par des périodes variables sans courant.

La tension appliquée est de quelques volts, généralement de 1 à 8 volts, de préférence de 2 à 7 volts, typiquement 3 volts pour 500 A.

A l'issue du refroidissement, généralement jusqu'à la température ambiante, par exemple de 20°C à 25°C, on récupère le matériau, à savoir la poudre frittée, préparé par le procédé selon l'invention dans l'appareil de « SPS ».

Une description analogue pourrait être faite de la densification d'une pièce ou de l'assemblage de deux pièces par le procédé selon l'invention.

L'invention va maintenant être décrite en référence aux exemples suivants, donnés à titre illustratif et non limitatif.

### EXEMPLES

Dans l'exemple 1, on fabrique des matrices et des pistons d'un appareil de SPS conformes à l'invention, c'est-à-dire des matrices et pistons dont les surfaces externes sont revêtues d'une couche en carbure de silicium SiC, d'une épaisseur de 1 à 10 µm.

Dans les exemples 2, 3, et 4, on réalise le frittage par SPS sous air, respectivement à 900°C, 1100°C et 1450°C, respectivement d'une poudre de TiO₂, d'une poudre de BaTiO₃, et d'une poudre de Al₂O₃, à l'aide d'un appareil de SPS équipé de la matrice et des pistons revêtus d'une couche en SiC fabriqués dans l'exemple 1.

### Exemple 1.

Dans cet exemple 1, on fabrique une matrice et deux pistons d'un appareil de SPS conforme à l'invention, c'est-à-dire des matrices et des pistons dont les surfaces externes sont revêtues d'une couche en carbure de silicium SiC, d'une épaisseur de 1 à 10 µm.

Pour cela, on traite dans un four de dépôt chimique en phase vapeur CVD, les matrices et les pistons en graphite d'un appareil de SPS comme celui de la Figure unique afin de revêtir les surfaces externes de ces matrices et pistons en graphite d'une couche en carbure de silicium SiC.

L'appareil de SPS est un appareil SPS-Dr Sinter® disponible auprès de la société SPS Syntex Inc®.

On enlève les pistons et la matrice de l'appareil et on les revêt par CVD.

Les paramètres des traitements de dépôt chimique en phase vapeur sont les suivants :
- le précurseur utilisé est le MTS (méthyltrichlorosilane),
- la température du dépôt est de 975°C;
- le débit d'hydrogène est de 450 sccm (« *standard cubic centimers per minute »* en anglais c'est-à-dire centimètres cubes standards par minute) ;
- le débit de MTS est de 150 sccm ;
- la durée du traitement est de 2,5 heures ;
- l'épaisseur du dépôt est de 1 à 10 µm ;

On peut facilement faire varier l'épaisseur du dépôt, par exemple en augmentant la durée du dépôt à la température donnée.

On fabrique ainsi plusieurs matrices et pistons dont les surfaces externes sont revêtues d'une couche en carbure de silicium SiC, d'une épaisseur de 1 à 10 µm.

Les matrices et pistons «en graphite ainsi traités, dont les surfaces externes sont revêtues d'une couche en carbure de silicium SiC, peuvent ensuite être mis en œuvre dans l'appareil de SPS de la même manière que les matrices et pistons en graphite non revêtus.

### Exemple 2.

Dans cet exemple, on réalise le frittage d'une poudre de TiO₂ par SPS sous air.

L'appareil de SPS est un appareil de SPS DR. SINTER® disponible auprès de la société SPS Syntex Inc® qui est équipé d'un ensemble constitué par une matrice et par des pistons en graphite revêtus par une couche en SiC comme cela a été décrit dans l'exemple 1.

La matrice est entourée d'une chemise en feutre de carbone.

Les paramètres du frittage par SPS sous air sont les suivants :
- Impulsions :
   - Impulsions de 3,3 ms de période ;
   - Trains de 12 impulsions, séparés par 2 périodes de la durée ci-dessus sans courant (« *12 ON et 2 OFF* ») ;
- Tension appliquée : jusqu'à 10 V.
- Cycle de Température :
   - Montée de la température ambiante jusqu'à 900°C : 9 minutes ;
   - Palier à 900°C : 3 minutes ;
   - Refroidissement de 900°C jusqu'à la température ambiante : durée conditionnée par l'inertie thermique de la machine.
- Cycle de Pression :
   De manière simultanée au cycle de température, le cycle de pression a été le suivant :
   - Montée de 0 à 40 MPa (pour une force appliqué de 3,lkN sur la surface de la matrice d'un diamètre de 10mm) : 1 minute ;
   - Palier à 40 MPa (3,lkN) : 11 minutes ;
   - Descente de la pression de 40 MPa (3,lkN) à 0 MPa (0 kN) : 1 minute.

Par rapport à un cycle de SPS classique, dans cet exemple, conforme à l'invention, le vide n'a pas été fait dans l'enceinte de l'appareil de SPS. Durant toute la durée de l'expérience, la chambre est donc restée sous air ambiant.

En comparant visuellement l'état des pistons et de la matrice avant, et après le frittage par SPS sous air, il est possible de constater qu'aucun de ces éléments n'est endommagé. L'ensemble constitué par la matrice et les pistons peut tout à fait être réutilisé.

### Exemple 3.

Dans cet exemple, on réalise le frittage d'une poudre de BaTiO₃ par SPS sous air.

L'appareil de SPS est un appareil de SPS DR. SINTER® disponible auprès de la société SPS Syntex Inc® qui est équipé d'un ensemble constitué par une matrice et par des pistons en graphite revêtus par une couche en SiC comme cela a été décrit dans l'exemple 1.

La matrice est entourée d'une chemise en feutre de carbone.

Les paramètres du frittage par SPS sous air sont les suivants :
- Impulsions :
   - Impulsions de 3,3 ms de période ;
   - Trains de 12 impulsions, séparés par 2 périodes de la durée ci-dessus sans courant (« *12 ON et 2 OFF* ») ;
- Tension appliquée : jusqu'à 10 V.
- Cycle de Température :
   - Montée de la température ambiante jusqu'à 1100°C : 11 minutes ;
   - Palier à 1100°C : 5 minutes ;
   - Refroidissement de 1100°C jusqu'à la température ambiante : durée conditionnée par l'inertie thermique de la machine.
- Cycle de Pression :
   De manière simultanée au cycle de température, le cycle de pression a été le suivant :
   - Montée de 0 à 40 MPa (pour une force appliqué de 3,lkN sur la surface de la matrice d'un diamètre de 10mm) : 1 minute ;
   - Palier à 40 MPa (3,lkN) : 15 minutes;
   - Descente de la pression de 40 MPa (3,lkN) à 0 MPa (0 kN) : 1 minute.

Par rapport à un cycle de SPS classique, dans cet exemple, conforme à l'invention, le vide n'a pas été fait dans l'enceinte de l'appareil de SPS.

Durant toute la durée de l'expérience, la chambre est donc restée sous air ambiant, tout comme dans l'exemple 2.

En comparant visuellement l'état des pistons et de la matrice avant, et après le frittage par SPS sous air, il est possible de constater qu'aucun de ces éléments n'est endommagé, tout comme dans l'exemple 2.

L'ensemble constitué par la matrice et les pistons peut tout à fait être réutilisé.

### Exemple 4.

Dans cet exemple, on réalise le frittage d'une poudre de Al₂O₃ par SPS sous air.

L'appareil de SPS est un appareil de SPS DR. SINTER® disponible auprès de la société SPS Syntex Inc® qui est équipé d'un ensemble constitué par une matrice et par des pistons en graphite revêtus par une couche en SiC comme cela a été décrit dans l'exemple 1.

La matrice est entourée d'une chemise en feutre de carbone.

Les paramètres du frittage par SPS sous air sont les suivants :
- Impulsions :
   - Impulsions de 3,3 ms de période ;
   - Trains de 12 impulsions, séparés par 2 périodes de la durée ci-dessus sans courant (« *12 ON et 2 OFF* ») ;
- Tension appliquée : jusqu'à 10 V.
- Cycle de température :
   - Montée de la température ambiante jusqu'à 600°C : 4 minutes ;
   - Palier à 600°C : 3 minutes ;
   - Montée de 600°C à 1450°C : 8 minutes ;
   - Palier à 1450 °C : 5 minutes ;
   - Refroidissement de 1450°C jusqu'à la température ambiante : durée conditionnée par l'inertie thermique de la machine.
- Cycle de Pression :
   De manière simultanée au cycle de température, le cycle de pression a été le suivant :
   - Montée de 0 à 40 MPa (pour une force appliqué de 3,lkN sur la surface de la matrice d'un diamètre de 10mm) : 1 minute ;
   - Palier à 40 MPa (3,lkN) : 21 minutes ;
   - Descente de la pression de 40 MPa (3,lkN) à 0 MPa (0 kN) : 1 minute.

Par rapport à un cycle de SPS classique, dans cet exemple, conforme à l'invention, le vide n'a pas été fait dans l'enceinte de l'appareil de SPS.

Durant toute la durée de l'expérience, la chambre est donc restée sous air ambiant, tout comme dans les exemples 2 et 3.

Comme dans les deux expérimentations précédentes, la matrice est entourée d'un feutre en carbone.

Ce feutre est totalement consommé au cours de l'expérimentation.

L'observation visuelle de l'ensemble de la chambre (par ensemble de la chambre on entend la chambre constituée par la matrice et les pistons) de l'appareil de SPS en cours de frittage sous air en fin de palier à 1450°C montre un ensemble piston et matrice très rayonnant à 1450°C. Le feutre en train de se consumer n'est plus tenu que par les tresses de carbone.

L'observation visuelle de la matrice après le frittage permet de constater qu'elle possède un aspect bleuté et que des piqures sont apparues aux arêtes. Seul le feutre en carbone qui entourait le moule, qui lui n'avait pas été revêtu de SiC, a disparu.

Cela démontre le bénéfice apporté par le revêtement en SiC selon l'invention sur le moule et les deux pistons.

L'alumine obtenue après le frittage est translucide, ce qui est la preuve d'une densification quasi-totale.

### REFERENCES

[1] US-A-3,241,956.
[2] US-A-3,250,892.
[3] J. G. Noudem, S. Quetel-Weben, R. Retoux, G. Chevallier, C. Estrournes, Scripta Materialia 68 (2013) 949-952.
[4] H. B. Zhang, B. N. Kim, K. Morita, H. Yoshida, J. H. Lim, K. Hiraga, Journal of Alloys and Compounds 508 (2010) 196-199.
[5] Xialu Wei ET AL: Materials, vol. 8, no. 9, 10 septembre 2015 (2015-09-10), 6043-6061

## Revendications

1. Matrice d'appareil de frittage à chaud avec champ électrique pulsé, **caractérisée en ce que** ladite matrice est en graphite et les surfaces externes de ladite matrice sont revêtues par une couche en carbure de silicium d'une épaisseur de 1 à 10 µm, ladite couche en carbure de silicium étant en outre éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

2. Piston d'appareil de frittage à chaud avec champ électrique pulsé, **caractérisé en ce que** ledit piston est en graphite et les surfaces externes dudit piston sont revêtues par une couche en carbure de silicium d'une épaisseur de 1 à 10 µm, ladite couche en carbure de silicium étant en outre éventuellement revêtue par une ou plusieurs autre(s) couche(s) en un carbure autre que le carbure de silicium choisi parmi le carbure de hafnium, le carbure de tantale et le carbure de titane, la ou lesdites autre(s) couche(s) ayant chacune une épaisseur de 1 à 10 µm.

3. Matrice selon la revendication 1, dans laquelle les surfaces externes de ladite matrice sont revêtues d'une couche en carbure de silicium par un procédé de dépôt chimique en phase vapeur « CVD », et ladite couche en carbure de silicium est en outre éventuellement revêtue par une ou plusieurs autre(s) couche(s) en un carbure autre que le carbure de silicium choisi parmi le carbure de hafnium, le carbure de tantale et le carbure de titane, par un procédé de dépôt chimique en phase vapeur « CVD ».

4. Piston selon la revendication 2, dans laquelle les surfaces externes dudit piston sont revêtues d'une couche en carbure de silicium par un procédé de dépôt chimique en phase vapeur « CVD », et ladite couche en carbure de silicium est en outre éventuellement revêtue par une ou plusieurs autre(s) couche(s) en un carbure autre que le carbure de silicium choisi parmi le carbure de hafnium, le carbure de tantale et le carbure de titane, par un procédé de dépôt chimique en phase vapeur « CVD ».

5. Appareil de frittage à chaud avec champ électrique pulsé SPS comprenant une matrice et deux pistons, définissant une chambre de frittage, densification ou assemblage capable de recevoir une poudre à fritter, une pièce à densifier, ou des pièces à assembler, **caractérisé en ce que** ladite matrice est une matrice selon la revendication 1 ou 3 et lesdits pistons sont des pistons selon la revendication 2 ou 4.

6. Procédé de frittage d'une poudre, densification d'une pièce, ou assemblage de deux pièces par un procédé de frittage à chaud avec champ électrique pulsé SPS dans une atmosphère oxydante, **caractérisé en ce que** ledit procédé utilise l'appareil de frittage à chaud avec un champ électrique pulsé SPS selon la revendication 5.

7. Procédé selon la revendication 6, dans lequel l'atmosphère oxydante est choisie parmi les atmosphères de gaz contenant de l'oxygène comme l'oxygène pur, l'air tel que l'air ambiant, et l'air enrichi en oxygène.

8. Procédé selon la revendication 6 ou 7, dans lequel lors du procédé de frittage à chaud avec champ électrique pulsé SPS, on applique un courant électrique pulsé suffisant à la poudre, à la pièce, ou aux pièces, pour élever la température de la poudre, de la pièce, ou des pièces jusqu'à une température au moins égale à 700°C ou 800°C, de préférence de 700°C ou 800 °C à 2500°C, de préférence encore de 700°C ou 800°C à 1450°C, mieux de 900°C à 1450°C, mieux encore de 1100°C à 1450°C.

9. Procédé selon l'une quelconque des revendications 6 à 8, dans lequel à l'issue du frittage de la poudre, de la densification de la pièce, ou de l'assemblage des deux pièces par le procédé de frittage à chaud avec champ électrique pulsé SPS, on refroidit la poudre frittée, la pièce densifiée, ou l'assemblage des deux pièces, de préférence jusqu'à la température ambiante, et on récupère la poudre frittée refroidie, la pièce densifiée refroidie, ou l'assemblage des deux pièces refroidi.

10. Procédé selon l'une quelconque des revendications 6 à 9, dans lequel la poudre à fritter, la pièce à densifier, ou les pièces à assembler sont en un matériau choisi parmi les métaux, les alliages de métaux, les oxydes de métaux ou de métalloïdes y compris les oxydes mixtes de métaux ou de métalloïdes, les carbures de métaux ou de métalloïdes, les nitrures de métaux ou de métalloïdes, et leurs mélanges.

11. Procédé selon la revendication 10, dans lequel on réalise le frittage d'une poudre d'un oxyde de métal ou de métalloïde ou d'un mélange de poudres d'oxydes de métal ou de métalloïde.

12. Procédé selon la revendication 11, dans lequel le ou les oxyde(s) de métal ou de métalloïde est (sont) choisi(s) parmi le TiO₂, l'Al₂O₃, le BaTiO₃, et les pérovskites, par exemple de formule Ca_{0,9}Yb_{0,1}Mn0₃₋ₓ.

## Patentansprüche

1. Matrix einer Vorrichtung zum Heißsintern mit gepulstem elektrischem Feld,
**dadurch gekennzeichnet, dass**
die Matrix aus Graphit besteht und die Außenflächen der Matrix mit einer Siliziumkarbidschicht mit einer Dicke von 1 bis 10 µm beschichtet sind, wobei die Siliziumkarbidschicht ferner gegebenenfalls mit einer oder mehreren weiteren Schichten aus einem anderen Karbid als Siliziumkarbid, ausgewählt aus Hafniumkarbid, Tantalkarbid und Titankarbid, beschichtet ist, wobei die weitere Schicht bzw. weiteren Schichten jeweils eine Dicke von 1 bis 10 µm aufweisen.

2. Kolben einer Vorrichtung zum Heißsintern mit gepulstem elektrischem Feld,
**dadurch gekennzeichnet, dass**
der Kolben aus Graphit besteht und die Außenflächen des Kolbens mit einer Siliziumkarbidschicht mit einer Dicke von 1 bis 10 µm beschichtet sind, wobei die Siliziumkarbidschicht ferner gegebenenfalls mit einer oder mehreren weiteren Schichten aus einem anderen Karbid als Siliziumkarbid, ausgewählt aus Hafniumkarbid, Tantalkarbid und Titankarbid, beschichtet ist, wobei die weitere Schicht bzw. weiteren Schichten jeweils eine Dicke von 1 bis 10 µm aufweisen.

3. Matrix nach Anspruch 1,
wobei
die Außenflächen der Matrix mit einer Siliziumkarbidschicht mittels eines Verfahrens zur chemischen Dampfabscheidung "CVD" beschichtet sind und die Siliziumkarbidschicht ferner gegebenenfalls mit einer oder mehreren weiteren Schichten aus einem anderen Karbid als Siliziumkarbid, ausgewählt aus Hafniumkarbid, Tantalkarbid und Titankarbid, mittels eines Verfahrens zur chemischen Dampfabscheidung "CVD" beschichtet ist.

4. Kolben nach Anspruch 2,
wobei
die Außenflächen des Kolbens mit einer Siliziumkarbidschicht mittels eines Verfahrens zur chemischen Dampfabscheidung "CVD" beschichtet sind und die Siliziumkarbidschicht ferner gegebenenfalls mit einer oder mehreren weiteren Schichten aus einem anderen Karbid als Siliziumkarbid, ausgewählt aus Hafniumkarbid, Tantalkarbid und Titankarbid, mittels eines Verfahrens zur chemischen Dampfabscheidung "CVD" beschichtet ist.

5. Vorrichtung zum Heißsintern mit gepulstem elektrischen Feld SPS, enthaltend eine Matrix und zwei Kolben, die eine Sinter-, Verdichtungs- oder Zusammenfügung kammer definieren, die ein Sinterpulver, ein zu verdichtendes Teil oder zusammenzufügende Teile aufnehmen kann,
**dadurch gekennzeichnet, dass**
die Matrix eine Matrix nach Anspruch 1 oder 3 ist und die Kolben Kolben nach Anspruch 2 oder 4 sind.

6. Verfahren zum Sintern eines Pulvers, Verdichten eines Teils oder Zusammenfügen von zwei Teilen mittels eines Verfahrens zum Heißsintern mit gepulstem elektrischen Feld SPS in einer oxidierenden Atmosphäre,
**dadurch gekennzeichnet, dass**
bei dem Verfahren die Vorrichtung zum Heißsintern mit gepulstem elektrischen Feld SPS nach Anspruch 5 verwendet wird.

7. Verfahren nach Anspruch 6,
wobei
die oxidierende Atmosphäre ausgewählt ist aus Gasatmosphären, die Sauerstoff, wie reinem Sauerstoff, Luft, wie Umgebungsluft, und sauerstoffangereicherte Luft, enthalten.

8. Verfahren nach Anspruch 6 oder 7,
wobei
beim dem Verfahren zum Heißsintern mit gepulstem elektrischen Feld SPS ein ausreichender gepulster elektrischer Strom an das Pulver, das Teil oder die Teile angelegt wird, um die Temperatur des Pulvers, des Teils oder der Teile auf eine Temperatur zu erhöhen, die zumindest gleich 700 °C oder 800 °C, vorzugsweise 700 °C oder 800 °C bis 2500 °C, weiter bevorzugt 700 °C oder 800 °C bis 1450 °C, besser 900 °C bis 1450 °C oder noch besser 1100 °C bis 1450 °C ist.

9. Verfahren nach einem der Ansprüche 6 bis 8,
wobei
am Ende des Sinterns des Pulvers, der Verdichtung des Teils oder des Zusammenfügens der beiden Teile mittels des Verfahrens zum Heißsintern mit gepulstem elektrischen Feld SPS das gesinterte Pulver, das verdichtete Teil oder die Zusammenfügung der beiden Teile, vorzugsweise auf Umgebungstemperatur, abgekühlt wird und das abgekühlte gesinterte Pulver, das abgekühlte verdichtete Teil oder die abgekühlte Zusammenfügung der beiden Teile gewonnen wird.

10. Verfahren nach einem der Ansprüche 6 bis 9,
wobei
das zu sinternde Pulver, das zu verdichtende Teil oder die zusammenzufügenden Teile aus einem Material bestehen, ausgewählt aus Metallen, Metalllegierungen, Metall- oder Metalloidoxiden, einschließlich Mischoxiden aus Metallen oder Metalloiden, Karbiden aus Metallen oder Metalloiden, Nitriden aus Metallen oder Metalloiden, und deren Gemischen.

11. Verfahren nach Anspruch 10,
wobei
das Sintern eines Pulvers aus einem Metall- oder Metalloidoxid oder einem Gemisch aus Pulvern aus Metall- oder Metalloidoxiden erfolgt.

12. Verfahren nach Anspruch 11,
wobei
das bzw. die Metall- oder Metalloidoxide ausgewählt ist/sind aus TiO₂, Al₂O₃, BaTiO₃, Perowskiten, beispielsweise der Formel Ca_{0,9}Yb_{0,1}MnO₃₋ₓ.

## Claims

1. Die of a spark plasma sintering apparatus, **characterised in that** said die is made of graphite and the outer surfaces of said die are coated with a layer made of silicon carbide having a thickness of 1 to 10 µm , said layer made of silicon carbide being further optionally coated with one or more other layer(s) made of a carbide other than silicon carbide, chosen from hafnium carbide, tantalum carbide and titanium carbide, said other layer(s) each having a thickness of 1 to 10 µm.

2. Piston of a spark plasma sintering apparatus, **characterised in that** said piston is made of graphite and the outer surfaces of said piston are coated with a layer made of silicon carbide having a thickness of 1 to 10 µm, said layer made of silicon carbide being further optionally coated with one or more other layer(s) made of a carbide other than silicon carbide, chosen from hafnium carbide, tantalum carbide and titanium carbide, said other layer(s) each having a thickness of 1 to 10 µm.

3. Die according to claim 1, wherein the outer surfaces of said die are coated with a layer made of silicon carbide by a "CVD" chemical vapour deposition method, and said layer made of silicon carbide is further optionally coated with one or more other layer(s) made of a carbide other than silicon carbide, chosen from hafnium carbide, tantalum carbide and titanium carbide, by a "CVD" chemical vapour deposition method.

4. Piston according to claim 2, wherein the outer surfaces of said piston are coated with a layer made of silicon carbide by a "CVD" chemical vapour deposition method, and said layer made of silicon carbide is further optionally coated with one or more other layer(s) made of a carbide other than silicon carbide, chosen from hafnium carbide, tantalum carbide and titanium carbide, by a "CVD" chemical vapour deposition method.

5. Spark plasma sintering apparatus SPS comprising a die and two pistons, defining a sintering, densification or assembly chamber capable of receiving a powder to be sintered, a part to be densified, or parts to be assembled, **characterised in that** said die is a die according to claim 1 or 3 and said pistons are pistons according to claim 2 or 4.

6. Method for sintering a powder, densifying a part, or assembling two parts by a spark plasma sintering SPS method in an oxidising atmosphere, **characterised in that** said method uses the spark plasma sintering apparatus SPS according to claim 5.

7. Method according to claim 6, wherein the oxidising atmosphere is chosen from the atmospheres of gas containing oxygen such as pure oxygen, air such as ambient air, and air enriched with oxygen.

8. Method according to claim 6 or 7, wherein during the spark plasma sintering SPS method, a sufficient pulsed electric current is applied to the powder, to the part, or to the parts, in order to raise the temperature of the powder, of the part, or of the parts to a temperature at least equal to 700°C or 800°C, preferably from 700°C or 800 °C to 2500°C, more preferably from 700°C or 800°C to 1450°C, better from 900°C to 1450°C, even better from 1100°C to 1450°C.

9. Method according to any one of claims 6 to 8, wherein after sintering of the powder, densification of the part, or assembly of the two parts by the spark plasma sintering SPS method, the sintered powder, the densified part, or the assembly of the two parts is cooled, preferably to the ambient temperature, and the cooled sintered powder, the cooled densified part, or the cooled assembly of the two parts is recovered.

10. Method according to any one of claims 6 to 9, wherein the powder to be sintered, the part to be densified, or the parts to be assembled are made of a material chosen from metals, alloys of metals, oxides of metals or of metalloids, including the mixed oxides of metals or of metalloids, carbides of metals or of metalloids, nitrides of metals or of metalloids, and mixtures thereof.

11. Method according to claim 10, wherein the sintering of a powder of an oxide of a metal or a metalloid or of a mixture of powders of oxides of a metal or of a metalloid is carried out.

12. Method according to claim 11, wherein the oxide(s) of a metal or of a metalloid is(are) chosen from TiO₂, Al₂O₃, BaTiO₃, and perovskites, for example having the formula Ca_{0,9}Yb_{0,1}MnO₃₋ₓ.
